Europäisches Patentamt

European Patent Office

Office européen des brevets

(11) Veröffentlichungsnummer: **0 257 463**
**A2**

(12) **EUROPÄISCHE PATENTANMELDUNG**

(21) Anmeldenummer: 87111729.7

(22) Anmeldetag: 13.08.87

(51) Int. Cl.⁴: **C23C 14/34 , B22F 3/26**

(30) Priorität: 16.08.86 DE 3627775

(43) Veröffentlichungstag der Anmeldung:
02.03.88 Patentblatt 88/09

(84) Benannte Vertragsstaaten:
AT BE CH DE ES FR GB GR IT LI NL SE

(71) Anmelder: DEMETRON Gesellschaft für
Elektronik-Werkstoffe m.b.H.
Leipziger Strasse 10
D-6450 Hanau 1(DE)

(72) Erfinder: Hausselt, Jürgen, Dr.
Emeserweg 11
D-8755 Alzenau 4(DE)
Erfinder: Schittny, Stephan-U., Dr.
Rannenbergring 39
D-8755 Alzenau 1(DE)
Erfinder: Kaufmann, Dieter, Dipl.-Ing.
Unterdorf 6
D-6484 Birstein(DE)

(74) Vertreter: Nowak, Gerhard
DEGUSSA AG Fachbereich Patente
Rodenbacher Chaussee Postfach 1345
D-6450 Hanau 1(DE)

(54) Verfahren zur Herstellung von Targets.

(57) Es wird ein Verfahren zur Herstellung hochreiner, mechanisch stabiler Targets beschrieben, die spröde Phasen im Gleichgewichtszustand enthalten. Dazu wird zuerst ein poröser Körper aus einem Teil der höherschmelzenden Komponente hergestellt und mit dem Rest der Komponentenzusammensetzung getränkt. Dabei muß die Zusammensetzung des Tränkmaterials so gewählt werden, daß durch die Reaktion zwischen Tränkmaterial und porösem Körper keine tieferschmelzenden Phasenanteile entstehen.

## Verfahren zur Herstellung von Targets

Die Erfindung betrifft ein Verfahren zur Herstellung hochreiner und mechanisch stabiler Targets mit hoher Dichte, insbesondere Targets, die überwiegend aus Seltenen Erden und Übergangsmetallen oder aus Silizium und refraktären Metallen bestehen, für das Beschichten von Gegenständen mittels Kathodenzerstäubung oder Bedampfung, die aufgrund ihrer Zusammensetzung im Gleichgewichtszustand hohe Anteile an spröden Phasen enthalten und leicht mit der Umgebungsatmosphäre und/oder den Tiegelmaterialien reagieren.

Mit Hilfe der Kathodenzerstäubung (Sputtern) und des Bedampfens, können dünne Schichten auf Substraten erzeugt werden, deren Anwendung von funktionalen Schichten in der Elektronik und Datentechnik über Korrosions-und Verschleißschutzschichten bis zu optischen Schichten für dekorative und wärmetechnische Zwecke reicht.

Beim Kathodenzerstäuben findet zwischen Kathode (Target) und Gegenelektrode eine elektrische Gasentladung statt, bei der von den aufprallenden Ionen aus dem Target Teilchen von atomarer Größe herausgeschlagen und auf Substraten, die im Bereich der Gegenelektrode angeordnet sind, niedergeschlagen werden.

Als Gasentladungsatmosphäre werden entweder inerte Gase, wie beispielsweise Argon oder Helium, oder reaktive Gase, wie z.B. Sauerstoff, Stickstoff oder Acetylen, bei geringem Druck eingesetzt.

Beim Inertgassputtern besteht das Target üblicherweise aus dem Material, aus dem die zu bildende Schicht bestehen soll, während beim Reaktivsputtern die herausgeschlagenen Targetteilchen mit dem Reaktionsgas reagieren und in Form eines Reaktionsproduktes als Schicht niedergeschlagen werden.

Beim Bedampfungsverfahren wird das Targetmaterial im Vakuum durch Elektronenstrahl-oder Widerstandsbeheizung thermisch verdampft und als dünne Schicht auf dem Substrat abgeschieden.

Die Targets können üblicherweise - schmelztechnisch hergestellt werden mit entsprechender Nachbearbeitung durch umformende und spanende Verfahren, oder pulvermetallurgisch durch Pressen und Sintern entsprechender Pulver bzw. Pulvergemische.

Bei Targetmaterialien, die aufgrund ihrer Zusammensetzung höhere Anteile an spröden Phasen enthalten, erweisen sich schmelztechnische Herstellverfahren als problematisch, da solche Targets beim Abkühlen nach dem Gießen aufgrund von thermischen Spannungen Risse aufweisen und in Stücke zerfallen können. Darüberhinaus sind solche Materialien meist nicht mechanisch bearbeitbar, so daß bestimmte wünschenswerte Targetgeometrien nicht herstellbar sind.

Pulvermetallurgische Verfahren zeigen bei denjenigen Targetmaterialien Probleme, die höhere Anteile an reaktionsempfindlichen Komponenten enthalten, und z.B. mit dem Luftsauerstoff reagieren. Wegen der großen spezifischen Oberfläche der Pulver und der daraus resultierenden Reaktionsfreudigkeit lassen sich hochwertige Targetqualitäten z.B. mit niedrigem Sauerstoffgehalt nicht pulvermetallurgisch herstellen.

Außerdem weisen pulvermetallurgisch hergestellte Produkte meist eine zum Teil offene Restporosität auf, die bei sauerstoffempfindlichen Targetmaterialien wegen der möglichen Oxidation des gesamten Targets nicht tolerierbar ist.

Diese Herstellungsschwierigkeiten treten insbesondere bei Targets auf, die überwiegend Seltene Erden und Übergangsmetalle bzw. Silizium und refraktäre Metalle enthalten.

Es war daher Aufgabe der Erfindung, ein Verfahren zur Herstellung hochreiner und mechanisch stabiler Targets mit hoher relativer Dichte, insbesonders Targets, die überwiegend aus seltenen Erden und Übergangsmetallen oder aus Silizium und refraktären Metallen bestehen, für das Beschichten von Gegenständen mittels Kathodenzerstäubung oder Bedampfung zu entwickeln, die aufgrund ihrer Zusammensetzung im Gleichgewichtszustand hohe Anteile an spröden Phasen enthalten und leicht mit der Umgebungsatmosphäre und/oder den Tiegelmaterialien reagieren, wobei die Targets mechanisch bearbeitbar und porenfrei sein sollten. Diese Aufgabe wird erfindungsgemäß dadurch gelöst, daß zuerst aus zumindest einem Teil der höherschmelzenden Komponenten der gewünschten Targetzusammensetzung ein poröser Körper erzeugt wird, daß anschließend mit dem Rest der Targetkomponenten ein tiefschmelzendes Tränkmaterial hergestellt und der poröse Körper damit getränkt wird, wobei die Zusammensetzung des Tränkmaterials so gewählt werden muß, daß durch Reaktion des Tränkmaterials mit dem porösen Körper keine gegenüber dem Tränkmaterial merklich tieferschmelzenden Phasenanteile entstehen, und wobei die Tränkzeit durch ein entsprechendes Ofenprogramm so kurz gewählt werden muß, daß in bezug auf die Sprödigkeit nur vernachlässigbare Anteile an Gleichgewichtsphasen entstehen.

Vorzugsweise werden die gegenüber der Umgebungsatmosphäre und/oder Tiegelmaterialien reaktionsempfindlichen zugegeben.

Der poröse Körper, der zumindest einen Teil der höherschmelzenden Komponenten der gewünschten Targetzusammensetzung enthält, wird normalerweise als lose Pulverschüttung und/oder durch Pressen und/oder durch Sintern hergestellt. Er kann aber durchaus aus Drahtgeflechten, Drahtwolle, Vliesen oder Lochblechen sowie durch mechanische Bearbeitung von kompakten Materialien hergestellt sein.

Der Tränkvorgang kann, als Auflage-, Unterlage-, Tauch-oder Drucktränkung im Vakuum, unter Schutzgas oder in reduzierender Atmosphäre erfolgen. Die treibende Kraft für eine vollständige Tränkung sind die in den Poren wirkenden Kapillarkräfte und die gegenseitige Benetzungsfähigkeit.

Als Tränkmaterial wird eine tiefschmelzende Komponente der Targetzusammensetzung oder eine tiefschmelzende (z.B. eutektische) Legierung benutzt, die den Rest der erforderlichen Komponenten enthält. Die Zusammensetzung des Tränkmaterials muß dabei so gewählt werden, daß durch Reaktion mit dem porösen Körper keine Phasen entstehen, die eine merklich tiefere Schmelztemperatur aufweisen als das Tränkmaterial. Die Tränkzeit (Aufheizen, Halten bei Tränktemperatur, Abkühlen) muß so kurz gewählt werden, daß zwar eine vollständige Benetzung und Füllung des porösen Körpers stattfindet, die Reaktion zwischen Tränkmaterial und porösem Körper, bei der spröde Phasen entstehen würden, jedoch vernachlässigbar gering ist.

Die Gesamtzusammensetzung der Targets wird bei vollständiger Durchtränkung sowohl durch die Zusammensetzung des porösen Körpers und des Tränkmaterials, als auch durch das Porenvolumen des porösen Körpers bestimmt. Es ist daher notwendig, das Porenvolumen des porösen Körpers mit Hilfe von z.B. abgesiebten Pulverfraktionen und entsprechenden Kompaktierungsbedingungen genau einzustellen.

Überraschenderweise führt dieses Herstellungsverfahren bei spröden und reaktionsempfindlichen Targetmaterialien zu kompakten, porenfreien, mechanisch stabilen Formteilen, die den Sputteranforderungen entsprechen und die für die Herstellung von komplizierten Geometrien mechanisch bearbeitbar sind. Sie weisen sehr geringe Gehalte an Gasen und Verunreinigungen auf. Der Tränkvorgang ermöglicht überraschenderweise neben der Entgasung im Vakuum oder in reduzierender Atmosphäre einen weiteren Reinigungsschritt: nicht geschmolzene Verunreinigungen, wie z.B. Oxide, die das Tränkmaterial gegebenenfalls aufweist, verbleiben nach dem Tränken als Schlacke außerhalb des Tränkkörpers, während nur gereinigte Schmelze in die Kapillaren des porösen Körpers gelangt.

In folgenden Beispielen soll das erfindungsgemäße Verfahren näher erläutert werden. —

1. Zur Herstellung von hochreinen, kompakten, mechanisch stabilen Sputtertargets zur Erzeugung von magnetooptischen Speicherschichten aus einer Eisen-Terbium-Legierung mit einem Gehalt von 25 At % Terbium wird ein poröser Eisenkörper sintertechnisch unter Vakuum aus Reinsteisenpulver hergestellt (1000° C/1h / $10^{-4}$ Pa).

Die Korngrößenverteilung des Eisenpulvers muß durch Absieben so ausgewählt werden, daß bei den obigen Sinterbedingungen eine Porosität von 54,3 % eingestellt wird. Diese Porosität erreicht man, indem eine Fraktion von 50-150 μm Teilchengröße mit linearer RRS-Verteilung (Din 66145) verwendet wird.

Die Zusammensetzung des Tränkmaterials entspricht in diesem Fall der eutektischen Zusammensetzung des Systems Eisen-Terbium (72 At % Terbium, 847° C Schmelztemperatur), so daß bei vollständiger Durchtränkung die gewünschte Gesamtzusammensetzung von 25 At % Terbium, Rest Eisen, erhalten wird.

Der Tränkprozeß erfolgt als Auflagetränkung im Vakuumofen. Die benötigte Auflageplatte des Tränkmaterials kann schmelztechnisch im Vakuuminduktionsofen hergestellt werden. Legierungen der eutektischen Zusammensetzung sind hinreichend duktil und mechanisch stabil.

Nach dem Chargieren des Vakuumofens erfolgt der Tränkvorgang in drei Minuten bei 900° C/$10^{-6}$ mbar.

2. Bei einer Verlängerung der Tränkzeit auf 20 Minuten bei 900° C/$10^{-4}$ Pa, erfolgt über die Durchtränkung und Benetzung hinaus eine intensive Reaktion zwischen dem Tränkmaterial und dem Eisenkörper, bei der ein hoher Gefügeanteil an spröden Phasen entsteht. Das Target ist aufgrund der Sprödigkeit ähnlich wie bei - schmelztechnischer Herstellung nicht mechanisch stabil und zerfällt in einzelne Stücke.

Wird die Tränkzeit dagegen gemäß Beispiel 1 auf drei Minuten begrenzt, so erfolgt über die Durchtränkung hinaus keine nennenswerte Reaktion, so daß das Produkt eine gute mechanische Stabilität aufweist und auch komplizierte Geometrien durch spannende Bearbeitung herstellbar sind.

Die erzielbaren Gasgehalte liegen bei diesen Targetmaterialien unterhalb 500 ppm.

3. Zur Herstellung eines hochreinen, kompakten und mechanisch stabilen Tantalsilizid (TaSi₂)-Sputtertargets wird als zu tränkender Körper ein poröser Tantalkörper durch Sintern von hochreinem, agglomerierten Tantalpulver im Vakuum hergestellt (1480° C/ 1 h / $10^{-4}$ Pa) Es hat sich gezeigt, daß durch entsprechende Wahl der Korngrößenverteilung von 105-210 μm bei obigen Sinterbedingungen die notwendige Porosität von 69 % erreicht wird, so daß bei Verwendung von eutektischem Tränkmaterial (99 At % Silizium, 1 At % Tantal, $T_s$ = 1385° C) und bei vollständiger Durchtränkung die gewünschte Gesamtzusammensetzung von 66,6 At % Silizium erreicht wird.

Der Tränkprozeß erfolgt als Tauchtränkung im Vakuum bei 1450° C / 2 min / $10^{-4}$ Pa.

Die beschriebene Tränkverfahren lassen sich entsprechend den ähnlichen Verhältnissen auf alle Materialien auf der Basis von seltenen Erden und Übergangsmetallen bzw. Refraktärmetallen und Silicium übertragen, um hochreine, kompakte mechanisch stabile Targets herzustellen.

## Ansprüche

1. Verfahren zur Herstellung hochreiner und mechanisch stabiler Targets mit hoher relativer Dichte, insbesondere Targets, die überwiegend aus Seltenen Erden und Übergangsmetallen oder aus Silizium und refraktären Metallen bestehen, für das Beschichten von Gegenständen mittels Kathodenzerstäubung oder Bedampfung, die aufgrund ihrer Zusammensetzung im Gleichgewichtszustand hohe Anteile an spröden Phasen enthalten und leicht mit der Umgebungsatmosphäre und/oder Tiegelmaterialien reagieren,
dadurch gekennzeichnet,
daß zuerst zumindest aus einem Teil der höherschmelzenden Komponenten der gewünschten Targetzusammensetzung ein poröser Körper erzeugt wird, daß anschließend mit dem Rest der Targetkomponenten ein tiefschmelzendes Tränkmaterial hergestellt und der poröse Körper damit getränkt wird, wobei die Zusammensetzung des Tränkmaterials so gewählt werden muß, daß durch Reaktion des Tränkmaterials mit dem porösen Körper keine gegenüber dem Tränkmaterial merklich tieferschmelzenden Phasenanteile entstehen, und wobei die Tränkzeit durch ein entsprechendes Ofenprogramm so kurz gewählt werden muß, daß in bezug auf die Sprödigkeit nur vernachlässigbare Anteile an Gleichgewichtsphasen entstehen.

2. Verfahren nach Anspruch 1, dadurch gekennzeichnet, daß die gegenüber der Umgebungsatmosphäre und/oder Tiegelmaterialien reaktionsempfindlichen Komponenten im Tränkmaterial enthalten sind.